(19) Europäisches Patentamt

European Patent Office

Office européen des brevets

(11) **EP 0 711 034 B1**

(12) **FASCICULE DE BREVET EUROPEEN**

(45) Date de publication et mention
de la délivrance du brevet:
**20.02.2002 Bulletin 2002/08**

(51) Int Cl.⁷: **H03G 7/00**, H04N 5/20

(21) Numéro de dépôt: **95402461.8**

(22) Date de dépôt: **03.11.1995**

(54) **Dispositif de génération de fonctions de transfert définies par intervalles**

Vorrichtung zum Generieren von Übertragungsfunktionen in Segmenten

Generating means for transfer functions defined by intervals

(84) Etats contractants désignés:
**DE FR GB IT**

(30) Priorité: **07.11.1994 FR 9413333**

(43) Date de publication de la demande:
**08.05.1996 Bulletin 1996/19**

(73) Titulaire: **THOMSON multimedia
92648 Boulogne Cédex (FR)**

(72) Inventeur: **Elbert, Mark,
c/o Thomson Multimediamedia
F-92050 Paris La Défense (FR)**

(74) Mandataire: **Ruellan-Lemonnier, Brigitte et al
THOMSON multimedia, 46 quai A. Le Gallo
92648 Boulogne Cédex (FR)**

(56) Documents cités:
**EP-A- 0 478 389     US-A- 4 680 553**

• **NACHRICHTENTECHNIK ELEKTRONIK, 1981,
EAST GERMANY, vol. 31, no. 2, ISSN 0323-4657,
pages 77-81, KUHNEL C 'Principles of
logarithmic amplifiers'**
• **PATENT ABSTRACTS OF JAPAN vol. 014 no.
050 (P-0998) ,30 Janvier 1990 & JP-A-01 279381
(NEC CORP) 9 Novembre 1989,**

**Description**

L'invention concerne un dispositif de génération de fonctions de transfert définies par intervalles. Le dispositif conforme à l'invention peut notamment être utilisé pour amplifier ou atténuer certaines parties de la plage de luminance d'un signal vidéo. L'invention concerne aussi un dispositif récepteur et/ou de visualisation comprenant un tel dispositif.

Pour améliorer le confort visuel d'un téléspectateur, on peut être amené à amplifier ou à atténuer différemment certaines plages de luminance d'un signal vidéo. Par exemple, il peut être souhaitable d'amplifier les plages moyennes de luminance par rapport aux plages extrêmes: les gris seront alors plus clairs. On peut également souhaiter rendre plus sombres les plages sombres. Ce traitement est appelé "black stretch" ou "white stretch".

L'invention a pour but de proposer un dispositif de génération de fonctions de transfert par segments particulièrement avantageux en ce qu'il utilise peu d'éléments de circuit et en ce que ses paramètres de fonctionnement peuvent facilement être réglés. De plus, le dispositif présente une grande vitesse de fonctionnement.

L'invention a pour objet un dispositif de génération de fonctions de transfert par segments recevant un signal d'entrée et fournissant un signal de sortie, ledit dispositif comprenant au moins deux moyens d'amplification à gain différents recevant chacun ledit signal d'entrée ainsi qu'un commutateur commutant entre lesdits au moins deux moyens d'amplification en étant commandé par des moyens de comparaison, ledit commutateur sélectionnant la sortie d'un des moyens d'amplification pour former le signal de sortie, caractérisé en ce que les fonctions de transfert sont des fonctions continues dont les segments ont au moins un point commun correspondant à au moins une valeur de référence du signal d'entrée ; et en ce que les moyens de comparaison effectuent une comparaison entre le signal d'entrée et au moins une desdites valeurs de référence pour sélectionner l'un des au moins deux moyens d'amplification.

Selon un mode de réalisation particulier, le dispositif comporte deux moyens d'amplification dont l'un a un gain supérieur à 1 et l'autre a un gain inférieur ou égal à 1.

L'invention a aussi pour objet un dispositif de réception ou de visualisation de signaux vidéo caractérisé en ce qu'il comprend dans la chaîne de traitement du signal de luminance au moins un dispositif tel que ci-dessus. Selon un mode de réalisation particulier, l'un des moyens d'amplification est une cellule à gain dite cellule à gain de Gilbert.

Selon un mode de réalisation particulier, l'un des moyens d'amplification est une cellule à atténuation.

Selon un mode de réalisation particulier, l'un des moyens d'amplification est une cellule à gain unité.

Selon un mode de réalisation particulier, le dispositif conforme à l'invention comprend un convertisseur tension-courant.

Selon un premier mode de réalisation particulier, le dispositif comprend une paire différentielle de transistors, la base du premier transistor étant connectée à une première tension de polarisation, la base du second transistor recevant le signal à amplifier, les émetteurs de ces transistors étant reliés par une résistance, chaque émetteur étant d'autre part relié à une source de courant,

le collecteur du premier transistor étant connecté à l'émetteur d'un troisième transistor, le collecteur du second transistor étant connecté à l'émetteur d'un quatrième transistor, les bases des troisième et quatrième transistors étant connectés à une seconde tension de polarisation,

le dispositif comprenant également un cinquième et un sixième transistor dont les émetteurs sont connectés, le dispositif comprenant également un septième et un huitième transistor dont les émetteurs sont connectés, les bases des cinquième et septième transistors, respectivement des sixième et huitième transistors étant connectées à l'émetteur du quatrième transistor, respectivement du troisième transistor,

les collecteurs des quatrième, sixième et septième transistors, respectivement des troisième, cinquième et huitième transistors étant interconnectés et fournissant les courants de sortie du circuit,

les émetteurs de la paire formée par le cinquième et le sixième transistor étant connectés à une première sortie d'un commutateur,

les émetteurs de la paire formée par le septième et le huitième transistor étant connectés à une seconde sortie dudit commutateur,

l'entrée dudit commutateur étant reliée à une source de courant,

le commutateur étant commandé par un comparateur.

Selon un second mode de réalisation, le dispositif comprend une paire différentielle de transistors, la base du premier transistor étant connectée à une première tension de polarisation, la base du second transistor recevant le signal à amplifier, les émetteurs de ces transistors étant reliés par une résistance, chaque émetteur étant d'autre part relié à une source de courant,

le collecteur du premier transistor étant connecté à l'émetteur d'un troisième transistor, le collecteur du second transistor étant connecté à l'émetteur d'un quatrième transistor, les bases des troisième et quatrième transistors étant connectés à une seconde tension de polarisation,

le dispositif comprenant également un cinquième et un sixième transistor dont les émetteurs sont connectés, le dispositif comprenant également un septième et un huitième transistor dont les émetteurs sont connectés, les bases des quatrième et septième transistors, respectivement des troisième et huitième transistors étant connectées,

les bases des cinquième et sixième transistors étant connectées respectivement aux émetteurs des quatrième et troisième transistors,

les collecteurs des quatrième, sixième et septième transistors, respectivement des troisième, cinquième et huitième transistors étant interconnectés et fournissant les courants de sortie du circuit,

les émetteurs de la paire formée par le cinquième et le sixième transistors étant connectés à une première sortie d'un commutateur,

les émetteurs de la paire formée par le septième et le huitième transistors étant connectés à une seconde sortie dudit commutateur,

l'entrée dudit commutateur étant reliée à une source de courant,

le commutateur étant commandé par un comparateur.

Selon un mode de réalisation particulier, ledit commutateur est dégénéré.

Selon un mode de réalisation particulier, ledit comparateur compare le signal d'entrée avec une valeur de référence. Le point de changement de gain est obtenu lorsque le circuit est en équilibre, le signal d'entrée et la valeur de référence étant égales. On évite ainsi les discontinuités au niveau de ce point.

Selon un mode de réalisation particulier, au moins un courant de sortie est converti en tension.

Selon un mode de réalisation particulier, le dispositif conforme à l'invention est associé à un convertisseur courant-tension comprenant quatre transistors,

les bases des premiers et seconds transistors étant connectées à ladite seconde tension de référence, les émetteurs des premiers et seconds transistors étant connectées respectivement aux collecteurs des quatrième et troisième transistors, dont les émetteurs, reliés chacun à une source de courant sont connectés à travers une résistance,

la base du quatrième transistor étant reliée à ladite première tension de référence,

la base du troisième transistor fournissant la tension de sortie dudit convertisseur,

les collecteurs des premier et second transistors conduisant des courants égaux aux courants de sortie.

D'autres caractéristiques et avantages de l'invention apparaîtront à travers la description de deux modes de réalisation particuliers non limitatifs de l'invention, illustrés par les figures jointes parmi lesquelles

- la figure 1 représente la fonction de transfert du circuit conforme au premier exemple de réalisation de l'invention,
- la figure 2 représente sous forme schématique le circuit conforme au premier exemple de réalisation,
- la figure 3 représente la fonction de transfert du circuit conforme au second exemple de réalisation de l'invention,
- la figure 4 représente sous forme schématique le circuit conforme au second exemple de réalisation,
- la figure 5 représente sous forme schématique un convertisseur courant-tension utilisé selon un mode de réalisation particulier en conjonction avec les circuits des figures 2 ou 4,
- la figure 6 représente un schéma fonctionnel d'un récepteur de télévision.

Sur les figures, les mêmes éléments portent les mêmes références.

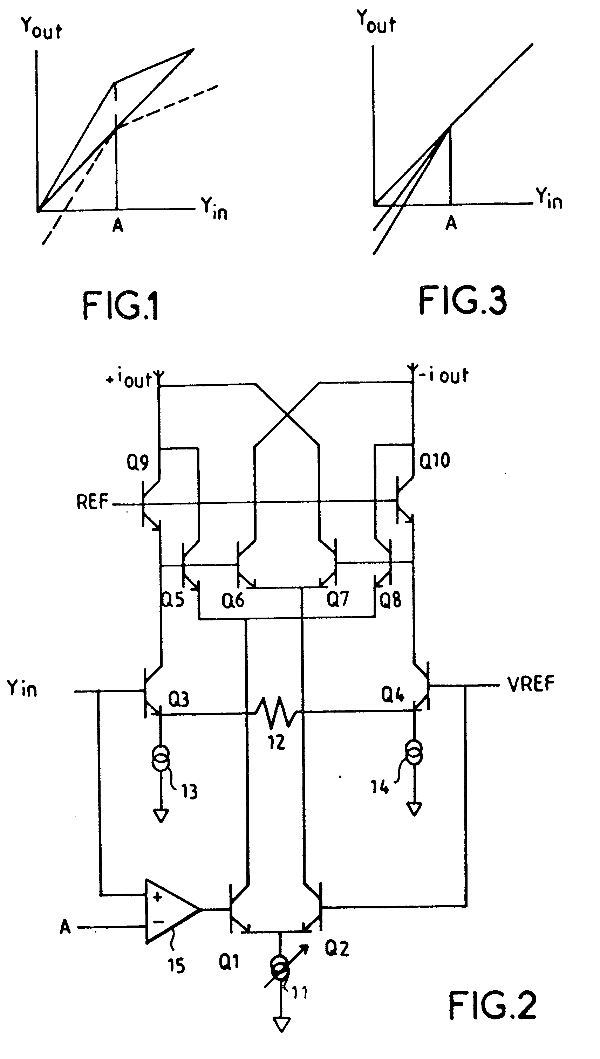

La figure 1 représente un premier exemple de fonction de transfert Yout=f(Yin) générée par un premier circuit conforme à l'invention. Selon cet exemple, un signal de luminance Yin est amplifié avec un gain $\alpha$ jusqu'à une valeur A de Yin, puis avec un gain $\beta$ à partir de la valeur A. Le gain $\alpha$ est caractérisé par une fonction de transfert sous forme de segment linéaire (en pointillé sur le schéma) dont la pente est supérieure à 1. Le gain $\beta$ est également caractérisé par une fonction de transfert en forme de segment de ligne, dont la pente égale à b est inférieure à 1. La fonction de transfert f est une fonction continue: les deux segments ont un point commun au niveau de l'abscisse A. La fonction de transfert du circuit de la figure 2 (suivi d'un convertisseur courant-tension dont un exemple de réalisation est décrit plus loin) est donnée en pointillé sur la figure 1. On ajustera de manière connue le niveau continu du signal en sortie de circuit pour obtenir f(0)=0.

Donc:

$$f(Yin) = \alpha Yin \text{ si} \qquad \text{si } O \leq Yin \leq A$$

$$f(Yin) = \beta Yin + A(\alpha - \beta) \qquad \text{si } A < Yin$$

La composante continue à ajouter a une valeur $(\alpha - 1)A$.

A est dénommé point de coupure dans ce qui suit. La figure 2 illustre un circuit permettant d'obtenir la fonction de transfert f. Le circuit comprend une paire de transistors NPN Q1 et Q2 dont les émetteurs sont connectés à une source de courant réglable 11.

La base de Q1 est reliée à la sortie d'un comparateur 15 qui compare la tension d'entrée Yin et une tension représentant le point de coupure.

La base de Q2 est reliée à une tension de polarisation Vref.

Q1 et Q2 forment un interrupteur qui permet de sélectionner entre les courants débités par deux cellules de gain, qui comprennent respectivement les transistors NPN Q5, Q8 et Q6, Q7. Pour ce faire, les émetteurs de Q5 et Q8 sont reliés au collecteur de Q1, tandis que les émetteurs de Q6 et Q7 sont reliés au collecteur de Q2.

Le circuit comprend également une paire différentielle de transistors NPN Q3 et Q4, dont les bases reçoivent respectivement Yin et la tension de polarisation Vref. Les émetteurs de Q3 et Q4 sont connectés à travers une résistance 12. Les émetteurs de Q3 et Q4 sont d'autre part connectés respectivement à des sources de courant de même valeur 13 et 14. Les transistors Q3, Q4 et la résistance 12 forment un convertisseur tension-courant.

Dans la suite, les intensités des courants débités par les différentes sources de courant seront désignés sous la forme Ix, où x est la référence de la source considérée.

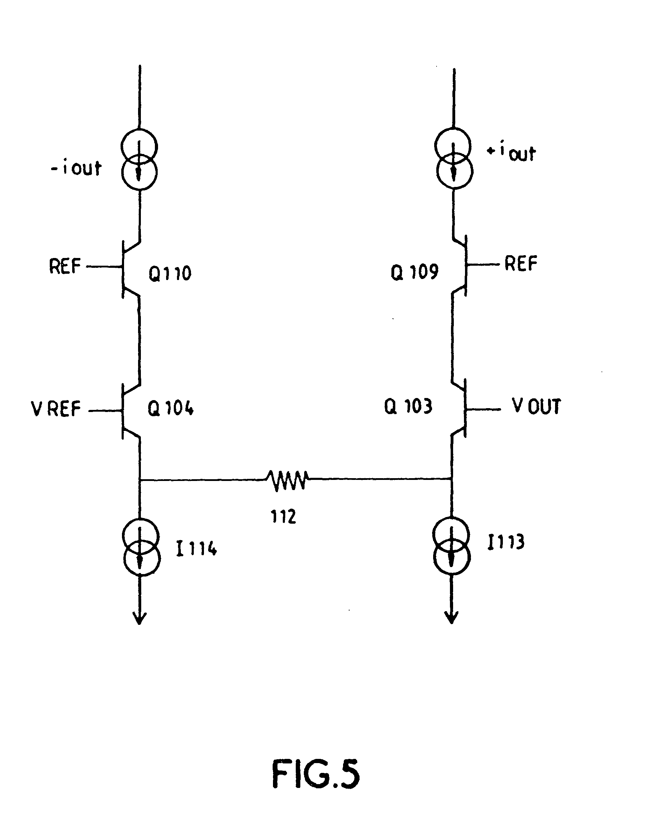

Le collecteur de Q3 est connecté à l'émetteur d'un transistor NPN Q9, dont le collecteur est connecté à un convertisseur courant-tension fournissant la tension de sortie Yout du circuit. Ce circuit est illustré par la figure 5, décrite ultérieurement.

De même, le collecteur de Q4 est connecté à l'émetteur d'un transistor NPN Q10, dont le collecteur est également connecté au convertisseur courant-tension. Les bases de Q9 et Q10 sont connectés à une tension de polarisation REF.

Les bases des deux transistors Q5 et Q6 sont reliées à l'émetteur de Q9, tandis que les bases de Q7 et Q8 sont reliées à l'émetteur de Q10.

Le collecteur de Q5 est relié au collecteur de Q9, tandis que le collecteur de Q8 est relié au collecteur de Q10.

Le collecteur de Q6 est relié au collecteur de Q10, tandis que le collecteur de Q7 est relié au collecteur de Q9.

Les transistors Q9, Q6, Q7 Q10 forment une cellule à gain translinéaire aussi appelée cellule de Gilbert. Ce type de cellule est décrit en détail dans "A New Wide-Band Amplifier Technique" IEEE JSSC, Vol SC3, No 4, décembre 1968.

Le gain de cette cellule est donné approximativement par l'expression:

$$Ga = 1 + Go = 1 + \frac{I11}{2I13}$$

On a donc une amplification, fonction du courant réglable I11.

Les transistors Q9, Q5, Q8, Q10 forment une autre cellule. On notera que contrairement à la cellule précédente, les collecteurs des transistors centraux Q5 et Q8 ne sont pas croisés. L'expression de gain obtenu est la suivante:

$$Ga = 1 - Go = 1 - \frac{I11}{2I13}$$

Le gain est inférieur au gain précédemment obtenu.

Selon une variante de réalisation de ce premier exemple, l'interrupteur formé par les transistors Q1 et Q2 est dégénéré pour adoucir la transition au niveau du point de coupure.

La figure 3 représente un second exemple de fonction de transfert. De nouveau, la fonction de transfert globale, désignée par f2, est composée de deux segments de droite et peut être définie par:

$$f2(Yin) = \alpha Yin - \beta \text{ si } 0 \leq Yin \leq A$$

$$f2(Yin) = Yin \text{ si } Yin > A$$

On choisit $\alpha > 1$

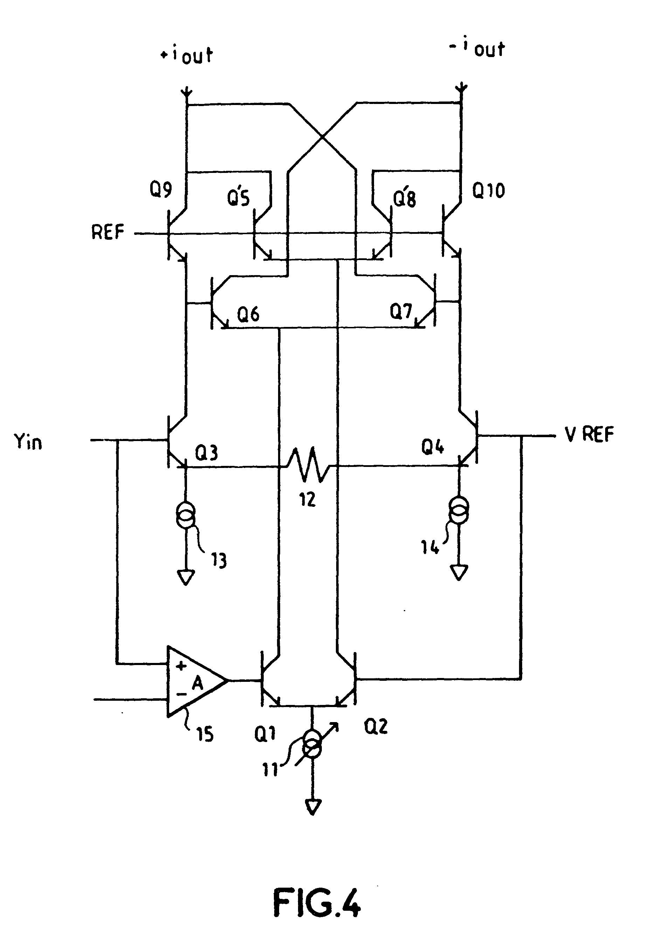

La figure 4 illustre le circuit correspondant. Le principe est similaire à celui du premier exemple. Ici, seuls les transistors Q5 et Q8 sont placés différemment et désignés sous la référence Q'5 et Q'8. En effet, les bases de ces transistors sont connectés à la même tension de polarisation REF que les bases des transistors Q9 et Q10.

Pour la cellule formée par Q6, Q7, Q9, Q10, l'expression du gain est la même que précédemment, tandis que le gain donné par Q'5 et Q'8 est de 1. La présence de la paire Q'5, Q'8 a pour but d'éviter les variations abruptes de courant de polarisation au niveau du point de coupure.

Les deux circuits présentés possèdent une sortie en courant au niveau des collecteurs de Q9, Q5, Q7 respectivement Q10, Q8, Q6 pour le circuit de la figure 2 et au niveau des collecteurs de Q9, Q'5, Q7, respectivement Q10, Q6, Q'8 pour le circuit de la figure 4.

Selon une variante de réalisation préférentielle, le circuit illustré par la figure 5 est utilisé pour la conversion en tension du courant de sortie du circuit de la figure 2. Le principe de ce circuit est de dupliquer certains courants présents dans le circuit dans une structure sensiblement symétrique. Le principe est identique pour le circuit de la figure 4.

Soient iout et -iout les courants circulant dans les conducteurs de sortie des circuits des figures 2 ou 4.

Le circuit de la figure 5 comprend notamment quatre transistors NPN Q103, Q104, Q109, Q110, qui sont les correspondants respectifs des transistors Q3, Q4, Q9, Q10. L'émetteur de Q109, respectivement Q110, est connecté au collecteur de Q103, respectivement Q104. L'émetteur de Q103, respectivement Q104, est connecté à une source de courant 113, repectivement 114. Bien évidemment, I113 = I114 = I13 = I14. Les émetteurs de Q103 et Q104 sont connectés à l'aide d'une résistance 112, égale à la résistance 12.

La base de Q104 est connectée à Vref, les bases de Q109 et Q110 au potentiel REF. Un miroir de courant duplique le courant iout dans le collecteur de Q109. Un second miroir de courant duplique le courant -iout dans le collecteur de Q110. La tension de sortie Vout est disponible sur la base de Q103.

La symétrie de ce circuit par rapport au circuit de la figure 2 a pour avantage de compenser certains défauts du circuit, notamment l'influence du courant de base des transistors Q9 et Q10.

Selon un mode de réalisation particulier, on prévoit un étage d'adaptation d'impédance connu en sortie du circuit de la figure 5.

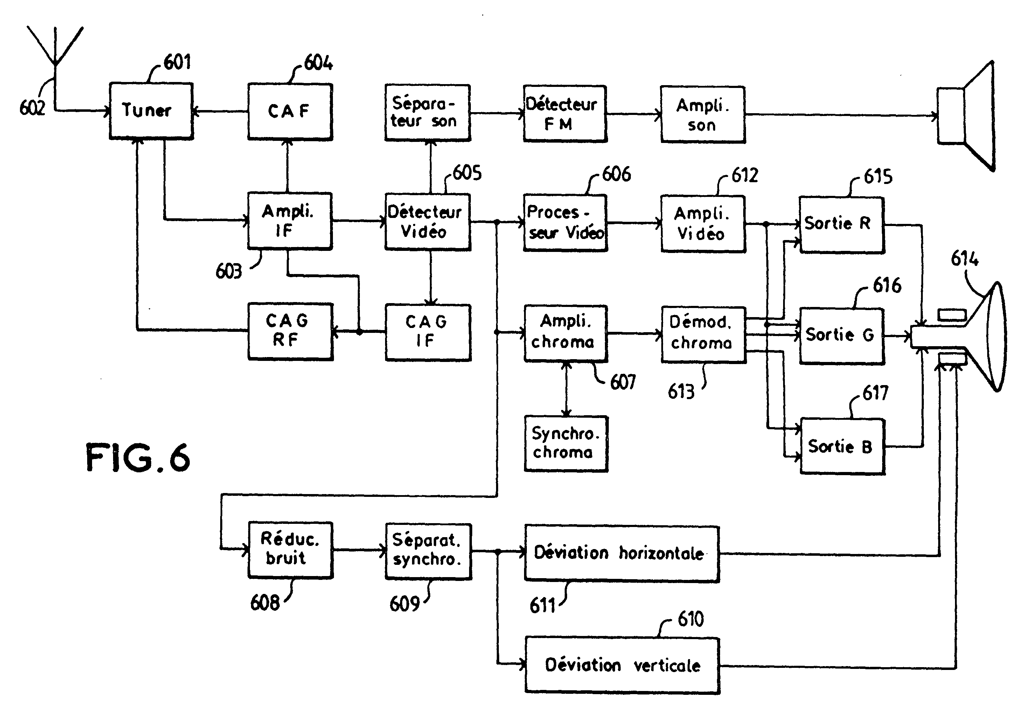

La figure 6 est un schéma fonctionnel d'un récepteur de télévision. Le tuner 601 de ce récepteur reçoit un signal RF par l'intermédiaire d'une antenne 602. Le signal en fréquence intermédiaire (IF) élaboré par le tuner 601 est amplifié par un amplificateur IF 603, ce dernier étant relié à un circuit de contrôle automatique de fréquence 604. Le signal IF amplifié est transmis à un détecteur vidéo 605. Le signal en bande de base résultant est traité par un processeur vidéo 606 pour ce qui est de la luminance, par un amplificateur de chrominance 607 pour ce qui est de la chrominance et par des circuits de synchronisation (608 à 611) pour ce qui est de la synchronisation horizontale et verticale. Un amplificateur vidéo 612 amplifie le signal de luminance Y fourni par le processeur vidéo 606, tandis qu'un circuit de démodulation 613 démodule la chrominance. Les signaux de luminance et de chrominance ainsi élaborés sont fournis de manière connue à une matrice de conversion pour l'obtention des signaux rouge, vert et bleu (RGB) commandant le tube cathodique 614. Cette matrice est symbolisée par les blocs 615 à 617

Selon le présent exemple de réalisation, le circuit conforme à l'invention est situé dans la chaîne de traîtement de la luminance, et de manière plus précise dans le processeur vidéo 606.

## Revendications

1. Dispositif de génération de fonctions de transfert par segments (f, f2) recevant un signal d'entrée (Yin) et fournissant un signal de sortie (iout, Yout), ledit dispositif comprenant au moins deux moyens d'amplification à gain différents ((Q9, Q10, Q6, Q7); (Q9, Q10, Q5, Q8); (Q9, Q10, Q'5, Q'8)) recevant chacun ledit signal d'entrée ainsi qu'un commutateur (Q1, Q2) commutant entre lesdits au moins deux moyens d'amplification en étant commandé par des moyens de comparaison (15), ledit commutateur (Q1, Q2) sélectionnant la sortie d'un des moyens d'amplification pour former le signal de sortie, **caractérisé en ce que**

   les fonctions de transfert sont des fonctions continues dont les segments ont au moins un point commun correspondant à au moins une valeur de référence (A) du signal d'entrée ; et **en ce que** les moyens de comparaison (15) effectuent une comparaison entre le signal d'entrée (Yin) et au moins une desdites valeurs de référence pour sélectionner l'un des au moins deux moyens d'amplification.

2. Dispositif selon la revendication 1, **caractérisé en ce qu'**il comporte deux moyens d'amplification dont l'un (Q9, Q10, Q6, Q7) a un gain supérieur à 1 et l'autre ((Q9, Q10, Q5, Q8); (Q9, Q10, Q'5, Q'8)) a un gain inférieur ou égal à 1.

3. Dispositif de réception ou de visualisation de signaux vidéo **caractérisé en ce qu'**il comprend dans la chaîne de traîtement du signal de luminance au moins un dispositif selon la revendication 1.

4. Dispositif selon l'une des revendications précédentes, **caractérisé en ce que** l'un des moyens d'amplification (Q9, Q10, Q6, Q7) est une cellule à gain dite cellule à gain de Gilbert.

5. Dispositif selon l'une des revendications précédentes, **caractérisé en ce que** l'un des moyens d'amplification (Q9, Q10, Q5, Q8) est une cellule à atténuation.

6. Dispositif selon l'une des revendications précédentes, **caractérisé en ce que** l'un des moyens d'amplification (Q9, Q10, Q'5, Q'8) est une cellule à gain unité.

7. Dispositif selon l'une des revendications précédentes, **caractérisé en ce qu'**il comprend un convertisseur tension-courant (Q3, Q4, 12).

8. Dispositif selon l'une des revendications précédentes, **caractérisé en ce qu'**il comprend une paire différentielle de transistors, la base du premier transistor (Q4) étant connectée à une première tension de polarisation (Vref), la base du second transistor (Q3) recevant le signal à amplifier (Yin), les émetteurs de ces transistors étant reliés par une résistance (12), chaque émetteur étant d'autre part relié à une source de courant (13, 14),

   le collecteur du premier transistor étant connecté à l'émetteur d'un troisième transistor (Q10), le collecteur du second transistor étant connecté à l'émetteur d'un quatrième transistor (Q9), les bases des troisième et quatrième transistors (Q10, Q9) étant connectées à une seconde tension de polarisation (REF), le dispositif comprenant également un cinquième (Q6) et un sixième transistor (Q7) dont les émetteurs sont connectés, le dispositif comprenant également un septième et un huitième transistor (Q5, Q8) dont les émetteurs sont connectés, les bases des cinquième et septième transistors (Q6, Q5), respectivement des sixième et huitième transistors (Q7, Q8) étant connectées à l'émetteur du quatrième transistor (Q9), respectivement du troisième transistor Q (10),

les collecteurs des quatrième, sixième et septième transistors (Q9, Q7, Q5), respectivement des troisième, cinquième et huitième transistors (Q10, Q6, Q8) étant interconnectés et fournissant les courants de sortie du circuit,

les émetteurs de la paire formée par le cinquième et le sixième transistor (Q6, Q7) étant connectés à une première sortie d'un commutateur (Q1,Q2),

les émetteurs de la paire formée par le septième et le huitième transistor (Q5, Q8) étant connectés à une seconde sortie dudit commutateur (Q1, Q2),

l'entrée dudit commutateur étant reliée à une source de courant (I11),

le commutateur étant commandé par un comparateur (15).

**9.** Dispositif selon l'une des revendications 1 à 7, **caractérisé en ce qu'**il comprend une paire différentielle de transistors, la base du premier transistor (Q4) étant connectée à une première tension de polarisation (Vref), la base du second transistor (Q3) recevant le signal à amplifier (Yin), les émetteurs de ces transistors étant reliés par une résistance (12), chaque émetteur étant d'autre part relié à une source de courant (13, 14),

le collecteur du premier transistor étant connecté à l'émetteur d'un troisième transistor (Q10), le collecteur du second transistor étant connecté à l'émetteur d'un quatrième transistor (Q9), les bases des troisième et quatrième transistors (Q10, Q9) étant connectés à une seconde tension de polarisation (REF),

le dispositif comprenant également un cinquième (Q6) et un sixième transistor (Q7) dont les émetteurs sont connectés, le dispositif comprenant également un septième et un huitième transistor (Q'5, Q'8) dont les émetteurs sont connectés, les bases des quatrième et septième transistors (Q9, Q'5), respectivement des troisième et huitième transistors (Q10, Q'8) étant connectées,

les bases des cinquième et sixième transistors (Q6, Q7) étant connectées respectivement aux émetteurs des quatrième et troisième transistors (Q9, Q10)

les collecteurs des quatrième, sixième et septième transistors (Q9, Q7, Q'5), respectivement des troisième, cinquième et huitième transistors (Q10, Q6, Q'8) étant interconnectés et fournissant les courants de sortie du circuit,

les émetteurs de la paire formée par le cinquième et le sixième transistors (Q6, Q7) étant connectés à une première sortie d'un commutateur (Q1,Q2),

les émetteurs de la paire formée par le septième et le huitième transistors (Q'5, Q'8) étant connectés à une seconde sortie dudit commutateur (Q1, Q2),

l'entrée dudit commutateur étant reliée à une source de courant (11),

le commutateur étant commandé par un comparateur (15).

**10.** Dispositif selon l'une des revendications précédentes, **caractérisé en ce que** ledit commutateur est dégénéré.

**11.** Dispositif selon l'une des revendications 8 ou 9, **caractérisé en ce qu'**au moins un courant de sortie (iout, -iout) est converti en tension (Yout).

**12.** Dispositif selon l'une des revendications 8 ou 9 **caractérisé en ce qu'**il est associé à un convertisseur courant-tension comprenant quatre transistors (Q109, Q110, Q103, Q104),

les bases des premiers et seconds transistors (Q109, Q110) étant connectées à ladite seconde tension de référence (REF),

les émetteurs des premiers et seconds transistors (Q109, Q110) étant connectées respectivement aux collecteurs des quatrième et troisième transistors (Q103, Q104), dont les émetteurs, reliés chacun à une source de courant (113, 114) sont connectés à travers une résistance (112),

la base du quatrième transistor (Q104) étant reliée à ladite première tension de référence (Vref),

la base du troisième transistor (Q103) fournissant la tension de sortie dudit convertisseur,

les collecteurs des premier et second transistors conduisant des courants égaux aux courants de sortie (iout,-iout).

**Patentansprüche**

**1.** Vorrichtung zum Erzeugen von Übertragungsfunktionen in Segmenten (f, f2), die ein Eingangssignal (Yin) empfängt und ein Ausgangssignal (iout, Yout) liefert, wobei die Vorrichtung wenigstens zwei Verstärkungsmittel mit unterschiedlichen Verstärkungen ((Q9, Q10, Q6, Q7); (Q9, Q10, Q5, Q8); (Q9, Q10, Q'5, Q'8)), von denen jedes das Eingangssignal empfängt, sowie einen Schalter (Q1, Q2) enthält, der zwischen den wenigstens zwei Verstärkungsmitteln umschaltet und durch Vergleichsmittel (15) gesteuert ist, und wobei der Schalter (Q1, Q2) den Ausgang eines der Verstärkungsmittel auswählt und dadurch das Ausgangssignal bildet, **dadurch gekennzeichnet, daß**

die Übertragungsfunktionen stetige Funktionen sind, deren Segmente wenigstens einen gemeinsamen Punkt haben, der wenigstens einem Referenzwert (A) des Eingangssignals entspricht,
und daß die Vergleichsmittel (15) einen Vergleich zwischen dem Eingangssignal (Yin) und wenigstens einem der Referenzwerte durchführen, um eines der wenigstens zwei Verstärkungsmittel auszuwählen.

2. Vorrichtung nach Anspruch 1, **gekennzeichnet durch** zwei Verstärkungsmittel, von denen eines (Q9, Q10, Q6, Q7) eine Verstärkung größer als 1 und das andere ((Q9, Q10, Q5, Q8); (Q9, Q10, Q'5, Q'8)) eine Verstärkung kleiner als 1 aufweist.

3. Vorrichtung zum Empfang und zur Wiedergabe von Videosignalen, **dadurch gekennzeichnet, daß** sie in dem Verarbeitungsweg des Luminanzsignals wenigstens eine Vorrichtung nach Anspruch 1 enthält.

4. Vorrichtung nach einem der vorangehenden Ansprüche, **dadurch gekennzeichnet, daß** eines der Verstärkungsmittel (Q9, Q10, Q6, Q7) eine sogenannte Gilbert-Verstärkungszelle ist.

5. Vorrichtung nach einem der vorangehenden Ansprüche, **dadurch gekennzeichnet, daß** die Verstärkungsmittel (Q9, Q10, Q5, Q8) durch eine Dämpfungszelle gebildet sind.

6. Vorrichtung nach einem der vorangehenden Ansprüche, **dadurch gekennzeichnet, daß** eines der Verstärkungsmittel (Q9, Q10, Q'5, Q'8) eine Zelle mit der Verstärkung eins ist.

7. Vorrichtung nach einem der vorangehenden Ansprüche, **dadurch gekennzeichnet, daß** sie einen Spannungs/Strom-Konverter (Q3, Q4, 12) enthält.

8. Vorrichtung nach einem der vorangehenden Ansprüche, **dadurch gekennzeichnet, daß** sie ein differentielles Paar von Transistoren enthält, daß die Basis des ersten Transistors (Q4) mit einer ersten Vorspannung (Vref) verbunden ist, daß die Basis des zweiten Transistors (Q3) das zu verstärkende Signal (Yin) empfängt, daß die Emitter dieser Transistoren über einen Widerstand (12) miteinander verbunden sind und jeder Emitter außerdem mit einer Stromquelle (13, 14) verbunden ist,

daß der Kollektor des ersten Transistors mit dem Emitter eines dritten Transistors (Q10) verbunden ist, der Kollektor des zweiten Transistors mit dem Emitter eines vierten Transistors (Q9) verbunden ist, die Basen des dritten und des vierten Transistors (Q10, Q9) mit einer zweiten Vorspannung (REF) verbunden sind,
daß die Vorrichtung außerdem einen fünften (Q6) und einen sechsten Transistor (Q7) enthält, deren Emitter miteinander verbunden sind, daß die Vorrichtung außerdem einen siebten und einen achten Transistor (Q5, Q8) enthält, deren Emitter miteinander verbunden sind, daß die Basen des fünften und siebten Transistors (Q6, Q5) bzw. des sechsten und achten Transistors (Q7, Q8) mit dem Emitter des vierten Transistors (Q9) bzw. des dritten Transistors (Q10) verbunden sind,
daß die Kollektoren des vierten, sechsten und siebten Transistors (Q9, Q7, Q5) bzw. des dritten, fünften und achten Transistor (Q10, Q6, Q8) miteinander verbunden sind und die Ausgangsströme der Schaltung liefern,
daß die Emitter des durch den fünften und sechsten Transistor (Q6, Q7) gebildeten Paars mit einem ersten Ausgang eines Schalters (Q1, Q2) verbunden sind,
daß die Emitter des durch den siebten und den achten Transistor (Q5, Q8) gebildeten Paares mit einem zweiten Ausgang des Schalters (Q1, Q2) verbunden sind,
daß der Eingang des Schalters mit einer Stromquelle (I11) verbunden ist und
daß der Schalter durch einen Komparator (15) gesteuert ist.

9. Vorrichtung nach einem der Ansprüche 1 bis 7, **dadurch gekennzeichnet, daß** sie ein differentielles Paar von Transistoren enthält, daß die Basis des ersten Transistors (Q4) mit einer ersten Vorspannung (VREF) verbunden ist, daß die Basis des zweiten Transistors (Q3) das zu verstärkende Signal (Yin) empfängt, daß die Emitter dieser Transistoren über einen Widerstand (12) miteinander verbunden sind, daß jeder Emitter andererseits mit einer Stromquelle (13, 14) verbunden ist,

daß der Kollektor des ersten Transistors mit dem Emitter eines dritten Transistors (Q10) verbunden ist, daß der Kollektor des zweiten Transistors mit dem Emitter eines vierten Transistors (Q9) verbunden ist, daß die Basen des dritten und vierten Transistors (Q10, Q9) mit einer zweiten Vorspannung (REF) verbunden sind,
daß die Vorrichtung außerdem einen fünften (Q6) und einen sechsten Transistor (Q7) enthält, deren Emitter miteinander verbunden sind, daß die Vorrichtung außerdem einen siebten und einen achten Transistor (Q'5, Q'8) enthält, deren Emitter miteinander verbunden sind, daß die Basen des vierten und siebten Transistors (Q9, Q'5) bzw. des dritten und achten Transistors (Q10, Q'8) miteinander verbunden sind,

daß die Basen des fünften und des sechsten Transistors (Q6, Q7) mit den Emittem des vierten bzw. dritten Transistors (Q9, Q10) verbunden sind,

daß die Kollektoren des vierten, sechsten und siebten Transistors (Q9, Q7, Q'5) bzw. des dritten, fünften und achten Transistors (Q10, Q6, Q'8) miteinander verbunden sind und die Ausgangsströme der Schaltung liefern,

daß die Emitter des durch den fünften und den sechsten Transistor (Q6, Q7) gebildeten Paares mit einem ersten Ausgang eines Schalters (Q1, Q2) verbunden sind,

daß die Emitter des durch den siebten und achten Transistor (Q5, Q8) gebildeten Paares mit einem zweiten Ausgang des Schalters (Q1, Q2) verbunden sind,

daß der Eingang des Schalters mit einer Stromquelle (11) verbunden und

daß der Schalter durch einen Komparator (15) gesteuert ist.

10. Vorrichtung nach einem der vorangehenden Ansprüche, **dadurch gekennzeichnet, daß** der Schalter degeneriert ist.

11. Vorrichtung nach einem der Ansprüche 8 oder 9, **dadurch gekennzeichnet, daß** wenigstens ein Strom am Ausgang (iout, -iout) in eine Spannung (Yout) umgesetzt wird.

12. Vorrichtung nach einem der Ansprüche 8 oder 9, **dadurch gekennzeichnet, daß** sie außerdem einen Strom/Spannungs-Konverter mit vier Transistoren (Q109, Q110, Q103, Q104) enthält,

daß die Basen des ersten und des zweiten Transistors (Q109, Q110) mit der zweiten Referenzspannung (REF) verbunden sind,

daß die Emitter des ersten und des zweiten Transistors (Q109, Q110) jeweils mit den Kollektoren des vierten und dritten Transistors (Q103, Q104) verbunden sind, deren Emitter, die beide mit einer Stromquelle (113, 114) verbunden sind, über einen Widerstand (112) miteinander verbunden sind,

daß die Basis des vierten Transistors (Q104) mit der ersten Referenzspannung (VREF) verbunden ist,

daß die Basis des dritten Transistors (Q103) die Spannung am Ausgang des Konverters liefert,

daß die Kollektoren des ersten und des zweiten Transistors Ströme führen, die gleich den Strömen (iout, -iout) am Ausgang sind.

**Claims**

1. Device for generating transfer functions in segments (f, f2) receiving an input signal (Yin) and supplying an output signal (iout, Yout), the said device comprising at least two amplification means with different gains ((Q9, Q10, Q6, Q7); (Q9, Q10, Q5, Q8) ; (Q9, Q10, Q'5, Q'8)) each receiving the said input signal, as well as a changeover switch (Q1, Q2) switching between the said at least two amplification means while being controlled by comparison means (15), the said changeover switch (Q1, Q2) selecting the output of one of the amplification means in order to form the output signal, **characterized in that**:

the transfer functions are continuous functions the segments of which have at least one common point corresponding to at least one reference value (A) of the input signal; and **in that** the comparison means (15) carry out a comparison between the input signal (Yin) and at least one of the said reference values in order to select one of the at least two amplification means.

2. Device according to Claim 1, **characterized in that** it includes two amplification means one of which (Q9, Q10, Q6, Q7) has a gain greater than 1 and the other of which (Q9, Q10, Q5, Q8); (Q9, Q10, Q'5, Q'8) has a gain less than or equal to 1.

3. Device for receiving or visually displaying video signals, **characterized in that** it comprises at least one device according to Claim 1 in the luminance-signal processing system.

4. Device according to one of the preceding claims, **characterized in that** one of the amplification means (Q9, Q10, Q6, Q7) is a gain cell called a Gilbert gain cell.

5. Device according to one of the preceding claims, **characterized in that** one of the amplification means (Q9, Q10, Q5, Q8) is an attenuation cell.

6. Device according to one of the preceding claims, **characterized in that** one of the amplification means (Q9, Q10, Q'5, Q'8) is a cell with unity gain.

7. Device according to one of the preceding claims, **characterized in that** it comprises a voltage/current converter (Q3, Q4, 12).

8. Device according to one of the preceding claims, **characterized in that** it comprises a differential pair of transistors, the base of the first transistor (Q4) being connected to a first bias voltage (Vref), the base of the second transistor (Q3) receiving the signal to be amplified (Yin), the emitters of these transistors being linked via a resistor (12), each emitter moreover being linked to a current source (13, 14),

the collector of the first transistor being connected to the emitter of a third transistor (Q10), the collector of the second transistor being connected to the emitter of a fourth transistor (Q9), the bases of the third and fourth transistors (Q10, Q9) being connected to a second bias voltage (REF),
the device also comprising a fifth (Q6) and a sixth (Q7) transistor the emitters of which are connected, the device also comprising a seventh and an eighth transistor (Q5, Q8) the emitters of which are connected, the bases of the fifth and seventh transistors (Q6, Q5), or of the sixth and eighth transistors (Q7, Q8) respectively, being connected to the emitter of the fourth transistor (Q9), or of the third transistor (Q10) respectively,
the collectors of the fourth, sixth and seventh transistors (Q9, Q7, Q5), or the third, fifth and eighth transistors (Q10, Q6, Q8) respectively, being interconnected and supplying the output currents of the circuit,
the emitters of the pair formed by the fifth and the sixth transistors (Q6, Q7) being connected to a first output of a changeover switch (Q1, Q2),
the emitters of the pair formed by the seventh and the eighth transistor (Q5, Q8) being connected to a second output of the said changeover switch (Q1, Q2),
the input of the said changeover switch being linked to a current source (I11),
the changeover switch being controlled by a comparator (15).

9. Device according to one of Claims 1 to 7, characterized in that it comprises a differential pair of transistors, the base of the first transistor (Q4) being connected to a first bias voltage (Vref), the base of the second transistor (Q3) receiving the signal (Yin) to be amplified, the emitters of these transistors being linked via a resistor (12), each emitter being, moreover, linked to a current source (13, 14),

the collector of the first transistor being connected to the emitter of a third transistor (Q10), the collector of the second transistor being connected to the emitter of a fourth transistor (Q9), the bases of the third and fourth transistors (Q10, Q9) being connected to a second bias voltage (REF),
the device also comprising a fifth (Q6) and a sixth (Q7) transistor the emitters of which are connected, the device also comprising a seventh and an eighth transistor (Q'5, Q'8) the emitters of which are connected, the bases of the fourth and seventh transistors (Q9, Q'5), or of the third and eighth transistors (Q10, Q'8) respectively, being connected,
the bases of the fifth and sixth transistors (Q6, Q7) being connected respectively to the emitters of the fourth and third transistors (Q9, Q10),
the collectors of the fourth, sixth and seventh transistors (Q9, Q7, Q'5), or of the third, fifth and eighth transistors (Q10, Q6, Q'8) respectively, being interconnected and supplying the output currents of the circuit,
the emitters of the pair formed by the fifth and the sixth transistors (Q6, Q7) being connected to a first output of a changeover switch (Q1, Q2),
the emitters of the pair formed by the seventh and the eighth transistors (Q'5, Q'8) being connected to a second output of the said changeover switch (Q1, Q2),
the input of the said changeover switch being linked to a current source (11),
the changeover switch being controlled by a comparator (15).

10. Device according to one of the preceding claims, **characterized in that** the said changeover switch is degenerate.

11. Device according to one of Claims 8 or 9, characterized in that at least one output current (iout, -iout) is converted into voltage (Yout).

12. Device according to one of Claims 8 and 9, **characterized in that** it is associated with a current/voltage converter comprising four transistors (Q109, Q110, Q103, Q104),

the bases of the first and second transistors (Q109, Q110) being connected to the said second reference voltage (REF),
the emitters of the first and second transistors (Q109, Q110) being connected respectively to the collectors of the fourth and third transistors (Q103, Q104), the emitters of which, each linked to a current source (113, 114), are connected via a resistor (112),

the base of the fourth transistor (Q104) being linked to the said first reference voltage (Vref), the base of the third transistor (Q103) supplying the output voltage of the said converter, the collectors of the first and second transistors conducting currents equal to the output currents (iout, -iout).

FIG.1

FIG.3

FIG.2

FIG.4

FIG.5

FIG.6

EP 0 711 034 B1